# EUROPEAN PATENT APPLICATION

(11) **EP 4 832 358 A1**
(43) Date of publication of application: **28.10.2026**
(21) Application number: 26167905.4
(22) Date of filing: 26.03.2026
(51) Int. Cl.: H04B 1/04

(54) **POWER COMPENSATION METHOD AND POWER COMPENSATION SYSTEM**

(30) Priority: 22.04.2025 TW 114115156
(71) Applicant: WNC Corporation, Hsinchu 308 (TW)
(72) Inventor: CHEN, Yung-Jinn, 308 Hsinchu (TW); PENG, Chen-Shu, 308 Hsinchu (TW)
(74) Representative: Vossius & Partner Patentanwälte Rechtsanwälte mbB

(57) **Abstract**

A power compensation method includes configuring a processor to obtain a power compensation controlling information corresponding to a plurality of ambient temperatures and write the power compensation controlling information into a running configuration of an electronic device; configuring the electronic device to perform the running configuration according to the power compensation controlling information and a current ambient temperature; configuring a temperature sensing module to sense a power amplifier to generate a sensed temperature; and after a period of time, configuring the processor to judge whether the sensed temperature is switched from a first temperature range to a second temperature range to generate a judgment result, and then determine whether the electronic device is configured to perform the running configuration according to the power compensation controlling information corresponding to the second temperature range based on the judgment result.

## Description

### BACKGROUND

### Technical Field

The present invention relates to a power compensation method and a power compensation system. More particularly, the present invention relates to a power compensation method and a power compensation system for transmission power with respect to temperature changes.

### Description of Related Art

Generally, in the product development of electronic device, if the power compensation mechanism to the maximum power output of the transmitter (TX) is not implemented, the following risks may be encountered: (1) Unstable performance: performance of the power amplifier may be degraded along with the ambient temperature change, causing an unstable output power. The consequence is a lowered signal quality, which may cause communication interruption or data transmission errors. (2) Overheating risk: the device may overheat without compensation in the high temperature environment, causing component damage or failure. The consequence is a shortened lifespan of the device, increasing maintenance and replacement costs. (3) Reduced efficiency: the efficiency of the power amplifier may be reduced when operating under non-optimal operating temperature, causing energy wastes. The consequence is an increased operation cost, and the overall performance of the system may be affected. (4) Signal distortion: temperature change may cause the increase of non-linear distortion, thereby the signal quality is affected. The consequence is lowered data transmission rate, requiring retransmission of data packets. (5) Reduced system reliability: long-term operation under unstable operating conditions may increase risks of systematic failure. The consequence is increasing maintenance frequency and operation interruption possibility. (6) Reduced user experience: inappropriate power-saving plans may lead to insufficient performance under high loading conditions. The consequence is the user may experience delay or unstable connection during high demand periods. Therefore, a power compensation method and a power compensation system with stable performance, no overheating risk, high efficiency, no signal distortion, enhanced system reliability, and promoted user experience are currently unavailable in the market.

### SUMMARY

A power compensation method, applied to an electronic device, is proposed according to one embodiment of the method aspect of the present invention, the electronic device includes at least one power amplifier. The power compensation method includes obtaining a power compensation controlling information corresponding to multiple ambient temperatures by a processor, and writing the power compensation controlling information into a running configuration of the electronic device, wherein the power compensation controlling information includes multiple temperature ranges corresponding to these ambient temperature, these temperature ranges include a first temperature range and a second temperature range, the first temperature range and the second temperature range are different; performing the running configuration by the electronic device according to the power compensation controlling information and a current ambient temperature, wherein the current ambient temperature corresponds to one of these ambient temperatures; sensing the at least one power amplifier by a temperature sensing module to generate at least one sensed temperature; and after a period of time, judging whether the at least one sensed temperature is switched from the first temperature range to the second temperature range by the processor to generate a judgment result, and determining, based on the judgment result, whether to perform the running configuration by the electronic device according to the power compensation controlling information corresponding to the second temperature range.

According to one embodiment, when the judgment result is Yes, the electronic device performs the running configuration according to the power compensation controlling information corresponding to the second temperature range; and when the judgment result is No, repeating the sensing the at least one power amplifier by the temperature sensing module.

According to one embodiment, the power compensation method further includes detecting a change of a total power of the electronic device by a power sensor, and judging whether the change of the total power is larger than the total power before change multiplied by a predetermined multiplier by the processor to generate a power change judgment result; and determining whether to perform a power compensation value adjustment process by the processor according to the power change judgment result. The power compensation value adjustment process includes adjusting a power compensation controlling parameter corresponding to one of the at least one power amplifier in the power compensation controlling information by the processor to generate an adjusted power compensation controlling parameter, and performing the running configuration by the electronic device according to the adjusted power compensation controlling parameter.

According to one embodiment, when the power change judgment result is Yes, performing the power compensation value adjustment process by the processor; and when the power change judgment result is No, repeating the sensing the at least one power amplifier by the temperature sensing module.

According to one embodiment, the power compensation controlling parameter includes an initial controlling parametric value and an offset controlling parametric value, the processor calculates the initial controlling parametric value and the offset controlling parametric value to generate an offset power compensation controlling parametric value, the adjusted power compensation controlling parameter is equal to the offset power compensation controlling parametric value subtracting a predetermined adjusting value.

According to one embodiment, the electronic device is an Open Radio Access Network (ORAN) Radio Unit (RU), the period of time is larger than or equal to 250 seconds and smaller than or equal to 350 seconds, the plurality of ambient temperatures are smaller than or equal to 55 degrees and larger than or equal to -40 degrees, the predetermined multiplier is larger than or equal to 1.01 and smaller than or equal to 1.09, the initial controlling parametric value is a positive integer, the offset controlling parametric value is larger than or equal to -1 and smaller than or equal to 1, the predetermined adjusting value is larger than or equal to 0.1 and smaller than or equal to 1.

According to one embodiment, the power compensation controlling information further includes a power compensation controlling parameter corresponding to one of the at least one power amplifier. The performing the running configuration by the electronic device according to the power compensation controlling information and the current ambient temperature further includes driving the one of the at least one power amplifier by the electronic device according to the power compensation controlling parameter corresponding to the current ambient temperature.

According to one embodiment, the power compensation method further includes applying a moving average approach to the at least one sensed temperature by the processor to record into a memory. The memory is connected to the processor.

According to one embodiment, the power compensation method further includes performing an information development process by the temperature sensing module and the processor to obtain the power compensation controlling information. The information development process includes sensing one of the at least one power amplifier by the temperature sensing module in a predetermined time interval to generate a plurality of measured temperature values, and calculating a mean after summing the plurality of measured temperature values to generate one of the at least one sensed temperature. The one of the at least one sensed temperature is a mean sensed temperature.

According to one embodiment, the information development process further includes obtaining a plurality of the mean sensed temperatures corresponding to the plurality of ambient temperatures by the processor, and calculating a median value according to two adjacent mean sensed temperatures of the plurality of mean sensed temperatures to obtain one of the plurality of temperature ranges. The one of the plurality of temperature ranges is equal to the median value.

A power compensation system, applied to an electronic device, is proposed according to one embodiment of the structural aspect of the present invention, the electronic device includes at least one power amplifier. The power compensation system includes a memory, a temperature sensing module and a processor. The memory is configured to store a power compensation controlling information and a current ambient temperature, wherein the power compensation controlling information corresponds to multiple ambient temperatures, and includes multiple temperature ranges corresponding to these ambient temperatures, these temperature ranges include a first temperature range and a second temperature range, the first temperature range and the second temperature range are different, the current ambient temperature corresponds to one of these ambient temperatures. The temperature sensing module is configured to sense the at least one power amplifier to generate at least one sensed temperature. The processor is connected to the memory and the temperature sensing module, the processor obtains the power compensation controlling information, and writes the power compensation controlling information into a running configuration of the electronic device. After a period of time, the processor judges whether the at least one sensed temperature is switched from the first temperature range to a second temperature range to generate a judgment result, and determines, based on the judgment result, whether to perform the running configuration by the electronic device according to the power compensation controlling information corresponding to the second temperature range. The electronic device performs the running configuration according to the power compensation controlling information and current ambient temperature.

According to one embodiment, when the judgment result is Yes, the electronic device performs the running configuration according to the power compensation controlling information corresponding to the second temperature range; and when the judgment result is No, the temperature sensing module repeats sensing the at least one power amplifier.

According to one embodiment, the power compensation system further includes a power sensor connected to the processor. The power sensor detects a change of a total power of the electronic device. The processor judges whether the change of the total power is larger than the total power before change multiplied by a predetermined multiplier to generate a power change judgment result, and determines whether to perform a power compensation value adjustment process according to the power change judgment result. The power compensation value adjustment process includes adjusting a power compensation controlling parameter corresponding to one of the at least one power amplifier in the power compensation controlling information to generate an adjusted power compensation controlling parameter, and performing the running configuration by the electronic device according to the adjusted power compensation controlling parameter.

According to one embodiment, when the power change judgment result is Yes, the processor performs the power compensation value adjustment process; and when the power change judgment result is No, the temperature sensing module repeats sensing the at least one power amplifier.

According to one embodiment, the power compensation controlling parameter includes an initial controlling parametric value and an offset controlling parametric value, the processor calculates the initial controlling parametric value and the offset controlling parametric value to generate an offset power compensation controlling parametric value, the adjusted power compensation controlling parameter is equal to the offset power compensation controlling parametric value subtracting a predetermined adjusting value.

According to one embodiment, the electronic device is an Open Radio Access Network (ORAN) Radio Unit (RU), the period of time is larger than or equal to 250 seconds and smaller than or equal to 350 seconds, the plurality of ambient temperatures are smaller than or equal to 55 degrees and larger than or equal to -40 degrees, the predetermined multiplier is larger than or equal to 1.01 and smaller than or equal to 1.09, the initial controlling parametric value is a positive integer, the offset controlling parametric value is larger than or equal to -1 and smaller than or equal to 1, the predetermined adjusting value is larger than or equal to 0.1 and smaller than or equal to 1.

According to one embodiment, the power compensation controlling information further includes a power compensation controlling parameter corresponding to one of the at least one power amplifier. The electronic device drives the one of the at least one power amplifier according to the power compensation controlling parameter corresponding to the current ambient temperature.

According to one embodiment, the processor applies a moving average approach to the at least one sensed temperature to record into the memory.

According to one embodiment, the temperature sensing module and the processor perform an information development process to obtain the power compensation controlling information. The information development process includes sensing one of the at least one power amplifier by the temperature sensing module under a predetermined time interval to generate a plurality of measured temperature values, and calculating a mean after summing the plurality of measured temperature values to generate one of the at least one sensed temperature. The one the at least one sensed temperature is a mean sensed temperature.

According to one embodiment, the information development process further includes obtaining a plurality of the mean sensed temperatures corresponding to the plurality of ambient temperatures by the processor, and calculating a median value according to two adjacent mean sensed temperatures of the plurality of mean sensed temperatures to obtain one of the plurality of temperature ranges. The one of the plurality of temperature ranges is equal to the median value.

### BRIEF DESCRIPTION OF THE DRAWINGS

The present disclosure can be more fully understood by reading the following detailed description of the embodiment, with reference made to the accompanying drawings as follows:
FIG. 1 is a schematic diagram of a power compensation system, illustrated in accordance with a first embodiment of the present invention.
FIG. 2 is a flowchart diagram of a power compensation method, illustrated in accordance with a second embodiment of the present invention.
FIG. 3 is a circuit block diagram of an electronic device, illustrated in accordance with the present invention.
FIG. 4 is a schematic diagram of a power compensation controlling information at an ambient temperature of 25 degrees, illustrated in accordance with the present invention.
FIG. 5 is a flowchart diagram of a power compensation method, illustrated in accordance with a third embodiment of the present invention.
FIG. 6 is a flowchart diagram of a power compensation method, illustrated in accordance with a fourth embodiment of the present invention.
FIG. 7 is a flowchart diagram of a power compensation method, illustrated in accordance with a fifth embodiment of the present invention.
FIG. 8 is a schematic diagram of a mean value calculation process and a median value calculation process, illustrated in accordance with an information development process in FIG. 7.
FIG. 9 is a schematic diagram of a power compensation controlling information at an ambient temperature of 55 degrees, illustrated in accordance with the present invention.
FIG. 10 is a schematic diagram of a power compensation controlling information at an ambient temperature of -45 degrees, illustrated in accordance with the present invention.

### DETAILED DESCRIPTION

The embodiment will be described with the drawings. For clarity, some practical details will be described below. However, it should be noted that the present disclosure should not be limited by the practical details, that is, in some embodiment, the practical details is unnecessary. In addition, for simplifying the drawings, some conventional structures and elements will be simply illustrated, and repeated elements may be represented by the same labels.

It will be understood that when an element (or device) is referred to as be "connected to" another element, it can be directly connected to the other element, or it can be indirectly connected to the other element, that is, intervening elements may be present. In contrast, when an element is referred to as be "directly connected to" another element, there are no intervening elements present. In addition, the terms first, second, third, etc. are used herein to describe various elements or components, these elements or components should not be limited by these terms. Consequently, a first element or component discussed below could be termed a second element or component.

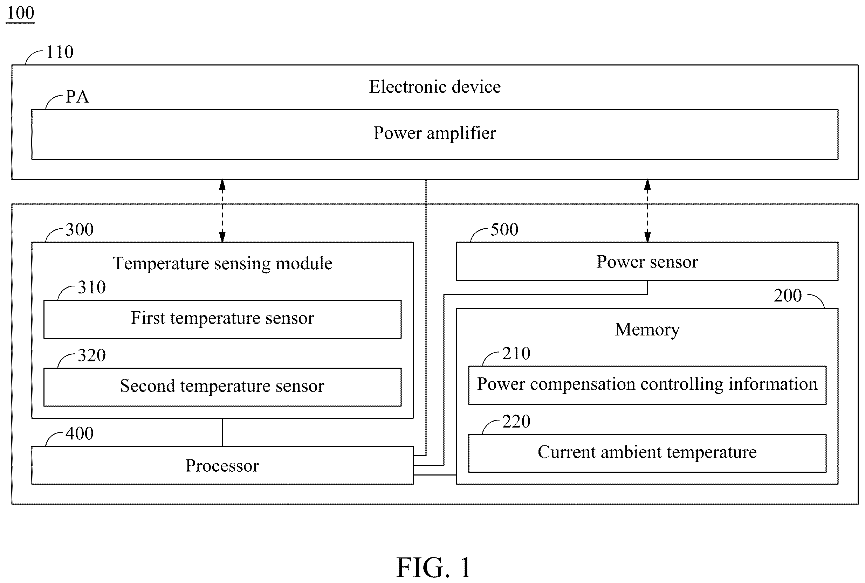

Reference is made to FIG. 1, FIG. 1 is a schematic diagram of a power compensation system 100, illustrated in accordance with the present invention. The power compensation system 100 is applied to an electronic device 110, the electronic device 110 includes at least one power amplifier PA. The power compensation system 100 includes a memory 200, a temperature sensing module 300, and a processor 400. The memory 200 is configured to store a power compensation controlling information 210 and a current ambient temperature 220. The power compensation controlling information 210 corresponds to multiple ambient temperatures, and includes multiple temperature ranges corresponding to these ambient temperatures. These temperature ranges include a first temperature range and a second temperature range, the first temperature range and the second temperature range are different. The current ambient temperature 220 corresponds to one of these ambient temperatures. The temperature sensing module 300 is configured to sense the at least one power amplifier PA to generate at least one sensed temperature. The processor 400 is connected to the memory 200 and the temperature sensing module 300. The processor 400 obtains the power compensation controlling information 210, and writes the power compensation controlling information 210 into a running configuration of the electronic device 110. After a period of time, the processor 400 judges whether the at least one sensed temperature is switched from the first temperature range to a second temperature range to generate a judgment result, and then determines, based on the judgment result, whether to perform a running configuration according to the power compensation controlling information 210 corresponding to the second temperature range by the electronic device 110. The electronic device 110 performs the running configuration according to the power compensation controlling information 210 and the current ambient temperature 220.

In one embodiment, the memory 200 mentioned above can be a Random Access Memory (RAM) or other types of dynamic storage device; the temperature sensing module 300 includes a first temperature sensor 310 and a second temperature sensor 320, wherein the first temperature sensor 310 is configured to sense the temperature of the power amplifier PA, the second temperature sensor 320 is configured to sense the ambient temperature, that is, the current ambient temperature 220 comes from the second temperature sensor 320; the processor 400 can be a Field Programmable Gate Array (FPGA), a Digital Signal Processor (DSP), a Micro Processing Unit (MPU), a Central Processing Unit (CPU), or other electronic processors. The present invention is not limited to the processors mentioned herein. Furthermore, the power compensation system 100 can further include a power sensor 500, the power sensor 500 is connected to the processor 400, and detects the change of the total power of the electronic device 110. The running configuration indicates multiple configuration data that are currently used by the device, which include all of the parameter configuration, network interfaces, resource allocation, and so on. These configuration data are loaded and applied when the device is powered on or restarted.

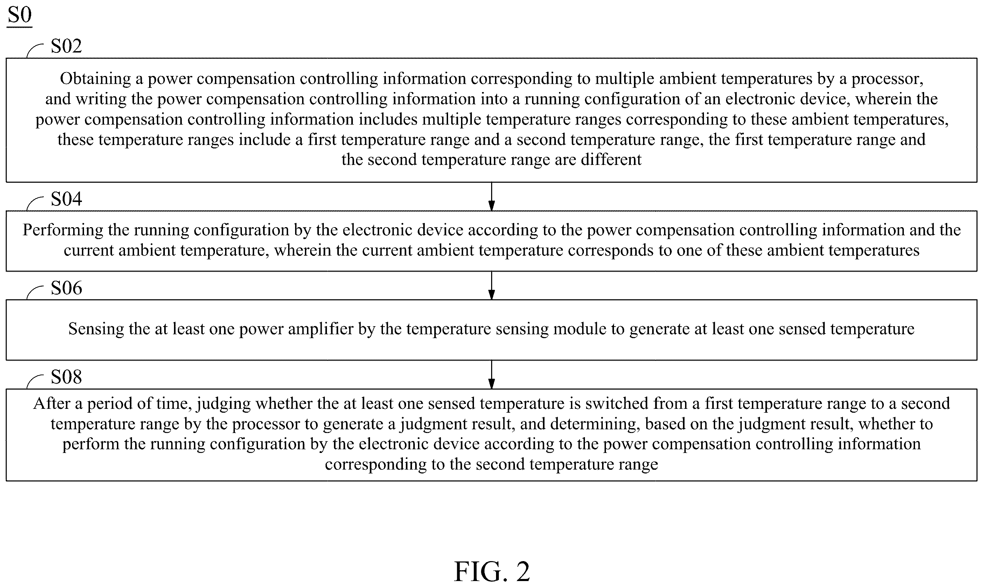

Reference is made to FIG. 1 and FIG. 2, wherein FIG. 2 is a flowchart diagram of a power compensation method S0, illustrated in accordance with a second embodiment of the present invention. The power compensation method S0 is applied to the electronic device 110 and the power compensation system 100, and includes executing processes S02, S04, S06, and S08. The process S02 includes the power compensation controlling information 210 corresponding to the multiple ambient temperature obtained by the processor 400, and writes the power compensation controlling information 210 into the running configuration of the electronic device 110. The power compensation controlling information 210 includes multiple temperature ranges corresponding to these ambient temperatures, these temperature ranges include a first temperature range and a second temperature range, the first temperature range and the second temperature range are different. The process S04 includes performing the running configuration by the electronic device 110 according to the power compensation controlling information 210 and the current ambient temperature 220, wherein the current ambient temperature 220 corresponds to one of these ambient temperatures. The process S06 includes sensing the at least one power amplifier PA by the temperature sensing module 300 to generate at least one sensed temperature. The process S08 includes, after a period of time, judging whether the at least one sensed temperature is switched from the first temperature range to the second temperature range by the processor 400 to generate a judgment result, and then determines, based on the judgment result, whether to perform the running configuration by the electronic device 110 according to the power compensation controlling information 210 corresponding to the second temperature range.

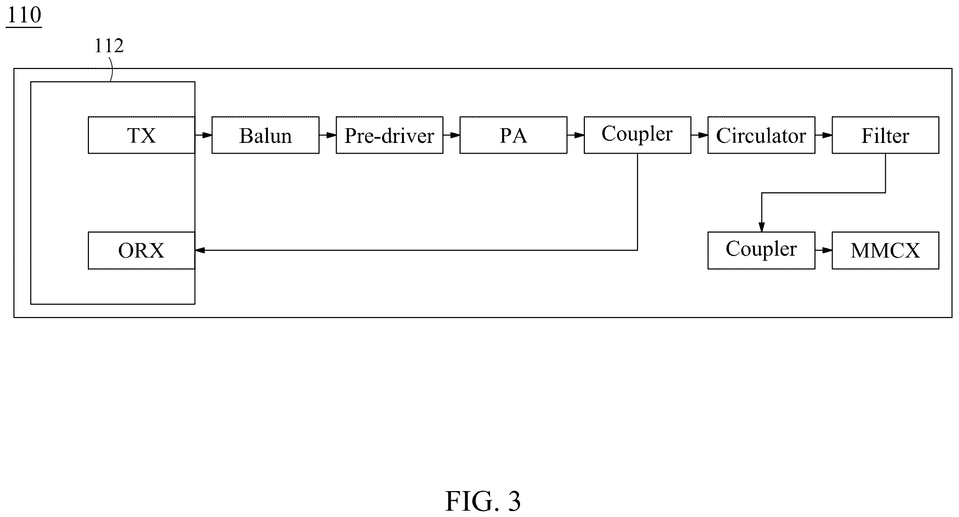

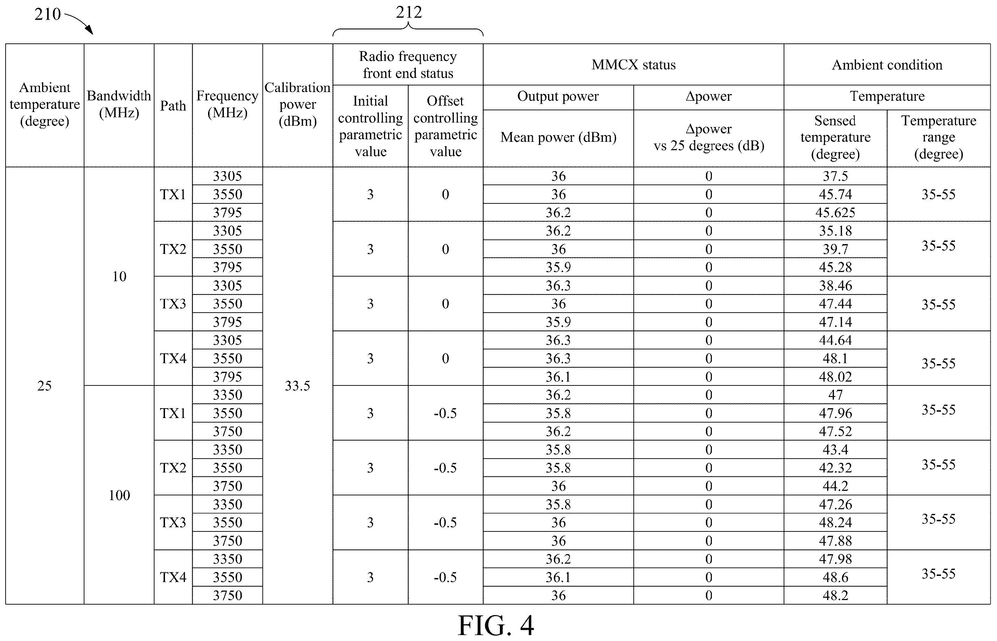

Reference is made to FIG. 1, FIG. 2, FIG. 3, and FIG. 4, wherein FIG. 3 is a circuit block diagram of the electronic device 110, illustrated in accordance with the present invention; and FIG. 4 is a schematic diagram of the power compensation controlling information 210 at the ambient temperature of 25 degrees, illustrated in accordance with the present invention. The electronic device 110 can be an Open Radio Access Network (ORAN) Radio Unit (RU), which includes a radio frequency front end module 112, a balun circuit, a pre-driver, a Power Amplifier (PA), a first coupler, a circulator, a filter, a second coupler and a connector (Micro-Miniature Coaxial Connector; MMCX). The radio frequency front end module 112 includes a transmitter TX and a receiver ORX. The electronic device 110 achieves the expected output power value through a Closed Loop Gain Control (CLGC). The electronic device 110 can monitor the powers of the transmitter TX and the receiver ORX, and control the power of the transmitter TX according to the receiver ORX to maintain the stability of the power. For example, assuming that the power of the transmitter TX and the power of the receiver ORX in a first timing are 37dBm and -17dBm, respectively, after a period of time, the power of the transmitter TX and the power of the receiver ORX in a second timing are 37dBm and -18dBm, respectively. Since the receiver ORX occurs a 1dBm of attenuation, therefore the power of the transmitter TX can be increased (to 38dBm) through CLGC, such that the power of the receiver ORX is maintained at -17dBm.

The power compensation controlling information 210 can be considered as a CLGC table related to CLGC, which includes multiple parameters. These parameters include an ambient temperature (degree), a bandwidth (MHz), a path (Chain), a frequency (MHz), a calibration power (dBm), a radio frequency front end status, a MMCX status, and an ambient condition, as illustratively shown in FIG. 4. Wherein the radio frequency front end status includes a power compensation controlling parameter 212 corresponding to one of multiple power amplifiers PA, the power compensation controlling parameter 212 includes an initial controlling parametric value and an offset controlling parametric value. The MMCX status includes an output power and a Δpower. The output power corresponds to a mean power (dBm); "the Δ power" represents the power difference, the value thereof is a difference of mean powers relative to the mean powers at the ambient temperature of 25 degrees (that is, "the Δpower vs 25 degrees (dB)"). The ambient condition includes a sensed temperature (degree) and a temperature range (degree). In addition, the "TX1", "TX2", "TX3", and "TX4" under the path represent four corresponding transmitting paths in the radio frequency front end module 112. For simplifying the diagram, a circuit block diagram of one transmitting path corresponding to one power amplifier PA is illustrated in FIG. 3.

In FIG. 2, the process S04 (that is, the process of performing the running configuration by the electronic device 110 according to the power compensation controlling information 210 and the current ambient temperature 220) further includes driving the one of multiple power amplifiers PA by the electronic device 110 according to the power compensation controlling parameter 212 corresponding to the current ambient temperature 220. The present invention thereby utilizes the power compensation controlling parameter 212 and CLGC technique to adaptably adjust the output power (TX power) of the radio frequency front end module 112, and effectively drives the corresponding power amplifier PA. Besides, the power compensation method S0 and the power compensation system 100 of the present invention can ensure that the system maintains a certain level of stability and performance under different ambient conditions (such as temperature changes under high temperature/ room temperature/ low temperature, bandwidth, or path changes) through specific power compensation mechanism.

In one embodiment, the bandwidth mentioned above can be 10MHz and 100MHz, as illustratively shown in FIG. 4. In some other embodiments, the bandwidth of the present invention can be applied to multi-bandwidth (such as, 5MHz, 20MHz, 50MHz, that is, any bandwidth within 3rd Generation Partnership Project (3GPP) standard). The present invention is not limited to the embodiments mentioned herein.

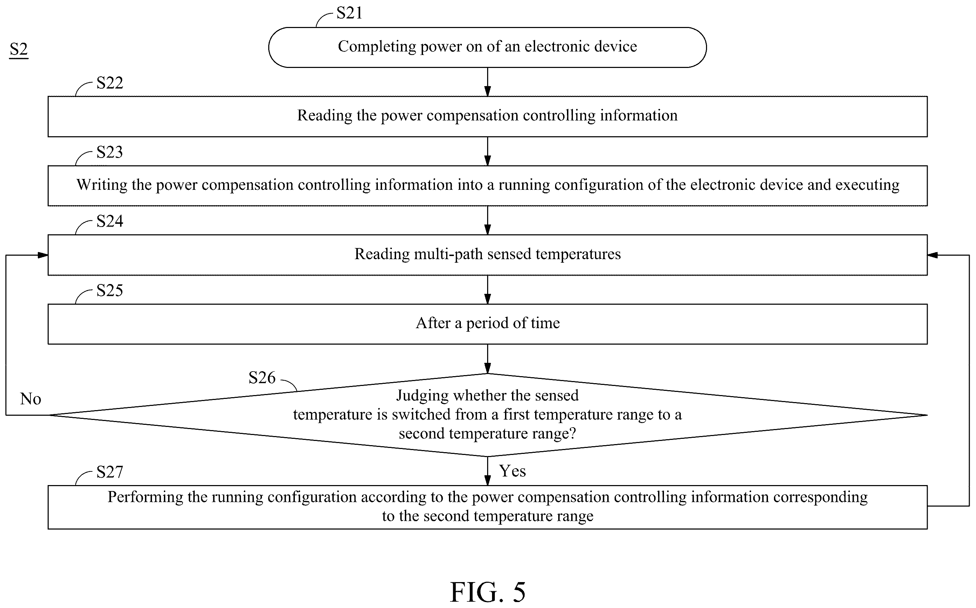

Reference is made to FIG. 1, FIG. 3, FIG. 4, and FIG. 5, wherein FIG. 5 is a flowchart diagram of a power compensation method S2, illustrated in accordance with a third embodiment of the present invention. The power compensation method S2 is applied to the electronic device 110 and the power compensation system 100, and includes executing processes S21, S22, S23, S24, S25, S26, S27. The process S21 includes completing power on of the electronic device 110. The process S22 includes reading the power compensation controlling information 210, that is, obtaining the power compensation controlling information 210 corresponding to multiple ambient temperatures by the processor 400. The process S23 includes writing the power compensation controlling information 210 into the running configuration of the electronic device 110 and executing. The process S24 includes reading multi-path sensed temperatures, that is, sensing the power amplifiers PA in multiple paths by the temperature sensing module 300 to generate multiple sensed temperatures. The process S25 includes after a period of time. The process S26 includes judging whether the at least one sensed temperature is switched from the first temperature range to the second temperature range by the processor 400 to generate a judgment result. The process S27 includes performing the running configuration according to the power compensation controlling information 210 corresponding to the second temperature range. When the judgment result is Yes, the electronic device 110 performs the process S27 (that is, performing the running configuration according to the power compensation controlling information 210 corresponding to the second temperature range). In contrast, when the judgment result is No, the temperature sensing module 300 repeats the process S24. Lastly, after the process S27 is performed, the process S24 is repeated.

In one embodiment, the period of time mentioned above can be larger than or equal to 250 seconds and smaller or equal to 350 seconds, the preferred value thereof is 300 seconds; these ambient temperatures can be smaller than or equal to 55 degrees and larger than or equal to -40 degrees, the preferred values thereof are 55 degrees, 25 degrees, 0 degrees, -20 degrees, and -40 degrees. The present invention is not limited to these values mentioned herein.

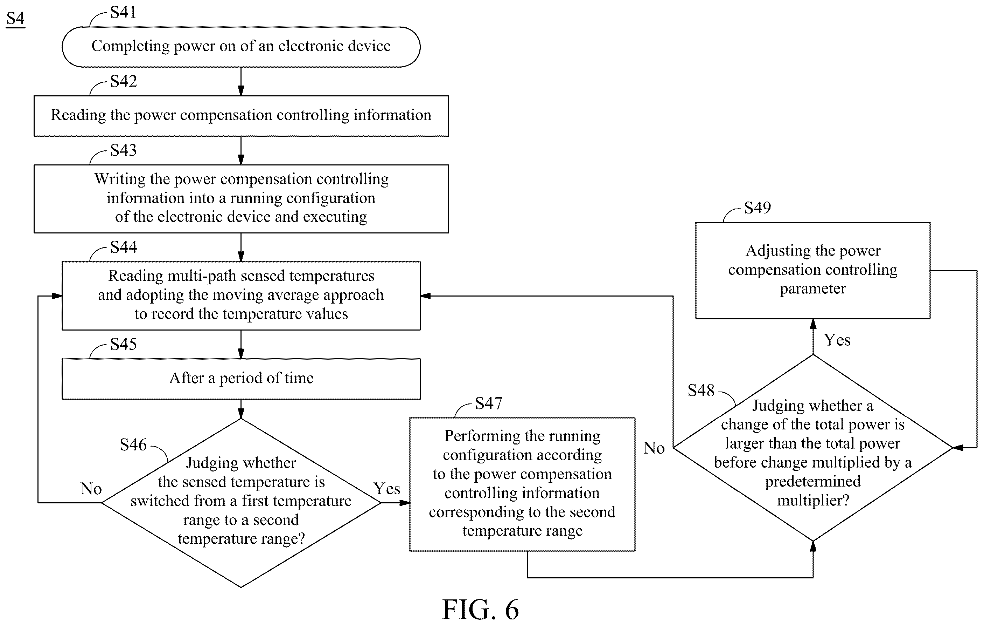

Reference is made to FIG. 1, FIG. 3, FIG. 4, FIG. 5, and FIG. 6, wherein FIG. 6 is a flowchart diagram of a power compensation method S4, illustrated in accordance with a fourth embodiment of the present invention. The power compensation method S4 is applied to the electronic device 110 and the power compensation system 100, and includes executing processes S41, S42, S43, S44, S45, S46, S47, S48, S49. Wherein the processes S41, S42, S43, S45, S46, S47 are the same as the processes S21, S22, S23, S25, S26, S27 in FIG. 5, respectively, which are not repeated herein.

The process S44 includes reading the multi-path sensed temperatures and adopting a moving average approach to record the temperature values; alternatively stated, the process S44 includes sensing the power amplifiers PA in multiple paths by the temperature sensing module 300 to generate multiple sensed temperatures, and applying the moving average approach to the multiple sensed temperatures by the processor 400 to record into the memory 200.

The process S48 includes detecting the change of the total power of the electronic device 110 by the power sensor 500, and judging whether the change of the total power is larger than the total power before change multiplied by a predetermined multiplier by the processor 400 to generate a power change judgment result, and determining whether to perform the process S49 by the processor 400 according to the power change judgment result.

The process S49 can be considered as a power compensation value adjustment process for the transmitting power with respect to the temperature change, which includes adjusting the power compensation controlling parameter 212 corresponding to one of the multiple power amplifiers PA in the power compensation controlling information 210 (corresponding to the second temperature range) by the processor 400 to generate an adjusted power compensation controlling parameter, and performing the running configuration by the electronic device 110 according to the adjusted power compensation controlling parameter. When the power change judgment result in the process S48 is Yes, the process S49 is performed. In contrast, when the power change judgment result in the process S48 is No, the process S44 is repeated. Besides, from FIG. 4, the power compensation controlling parameter 212 includes the initial controlling parametric value and the offset controlling parametric value. In the process S49, the processor 400 calculates the initial controlling parametric value and the offset controlling parametric value of the power compensation controlling parameter 212 to generate an offset power compensation controlling parametric value, and the adjusted power compensation controlling parameter is equal to the offset power compensation controlling parametric value subtracting a predetermined adjusting value. The power compensation method S4 of the present invention thereby combines the power compensation mechanism and energy saving mechanism with respect to temperature changes, which are effective to enhance systematic performance and stability and reduce energy consumption at the same time.

In one embodiment, the predetermined multiplier mentioned above can be larger than or equal to 1.01 and smaller than or equal to 1.09, the preferred value thereof is 1.05 (that is, 105%); the offset power compensation controlling parametric value is equal to the initial controlling parametric value adding the offset controlling parametric value; the initial controlling parametric value can be a positive integer, the preferred value thereof is 3; the offset controlling parametric value can be larger than or equal to -1 and smaller than or equal to 1; the predetermined adjusting value can be larger than or equal to 0.1 and smaller than or equal to 1, the preferred value thereof is 0.5. The present invention is not limited to the values mentioned herein.

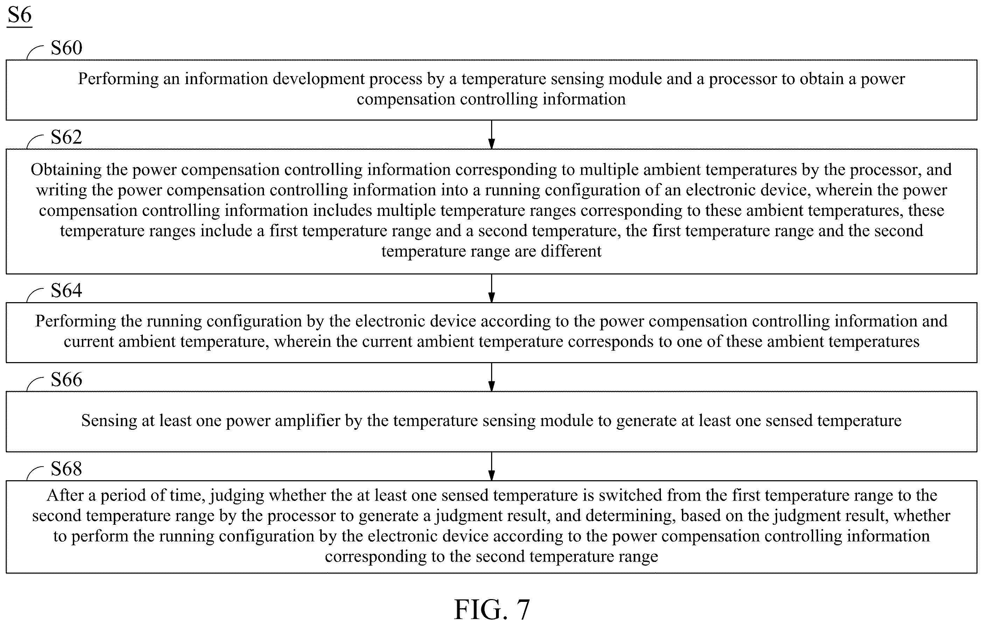

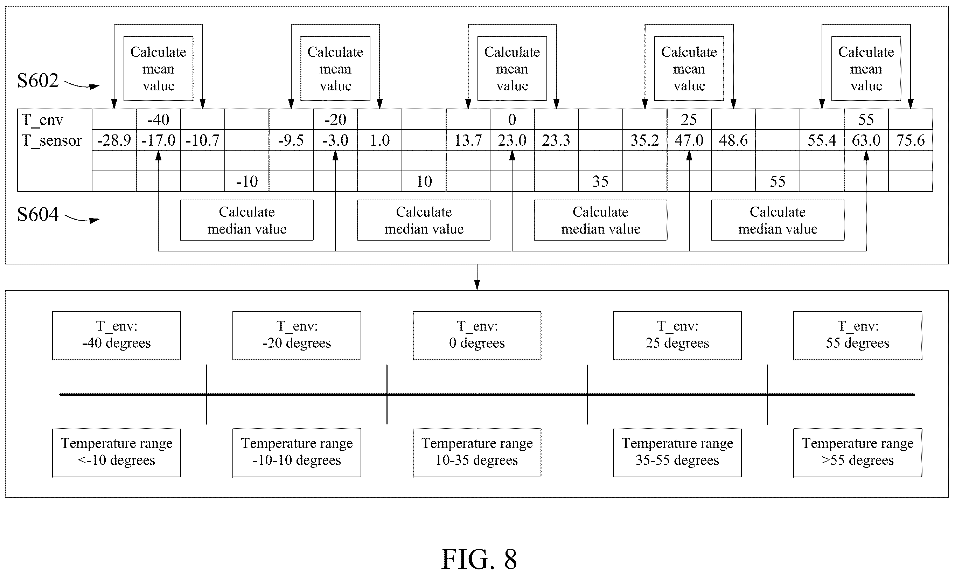

Reference is made to FIG. 1, FIG. 2, FIG. 3, FIG. 4, FIG. 7, and FIG. 8, wherein FIG. 7 is a flowchart diagram of a power compensation method S6, illustrated in accordance with a fifth embodiment of the present invention; and FIG. 8 is a schematic diagram of a mean value calculation process S602 and a median value calculation process S604, illustrated in accordance with an information development process in FIG. 7. The power compensation method S6 is applied to the electronic device 110 and the power compensation system 100, and includes executing processes S60, S62, S64, S66, S68. Wherein the processes S62, S64, S66, S68 are the same as the processes S02, S04, S06, S08 shown in FIG. 2, which are not repeated herein.

The process S60 includes performing the information development process by the temperature sensing module 300 and the processor 400 to obtain the power compensation controlling information 210. Specifically, the information development process includes performing the mean value calculation process S602 and the median value calculation process S604. The mean value calculation process S602 includes sensing one of the at least one power amplifier PA by the temperature sensing module 300 in a predetermined time interval to generate multiple measured temperature values (T_sensor), and calculating the mean after summing these measured temperature values to generate one of the at least one sensed temperature, wherein the one of the at least one sensed temperature is a mean sensed temperature. The median value calculation process S604 includes obtaining multiple mean sensed temperatures corresponding to these ambient temperatures (T_env) by the processor 400, and calculating a median value according to two adjacent mean sensed temperatures of these mean sensed temperatures, thereby obtaining one of these temperature ranges, wherein the one of these temperature ranges is equal to the median value.

In one embodiment, the quantity of the sensed temperatures (the mean sensed temperatures) mentioned above can be 5, which are -17.0 degrees, -3.0 degrees, 23.0 degrees, 47.0 degrees, and 63.0 degrees; the quantity of the median values can be 4, which are -10 degrees, 10 degrees, 35 degrees, and 55 degrees; the quantity of the temperature ranges can be 5, which are "<-10 degrees", "-10 to 10 degrees"(-10-10 degrees), "10 to 35 degrees"(10-35 degrees), "35 to 55 degrees"(35-55 degrees), and ">55 degrees"; the first temperature range mentioned in the power compensation methods S0, S2, S4, S6 of FIG. 2, FIG. 5, FIG. 6, FIG. 7 can be a temperature range between 35 degrees to 55 degrees (that is, "35 to 55 degrees"), the second temperature range can be a temperature range larger than 55 degrees (that is, ">55 degrees"). The present invention is not limited to these values mentioned herein.

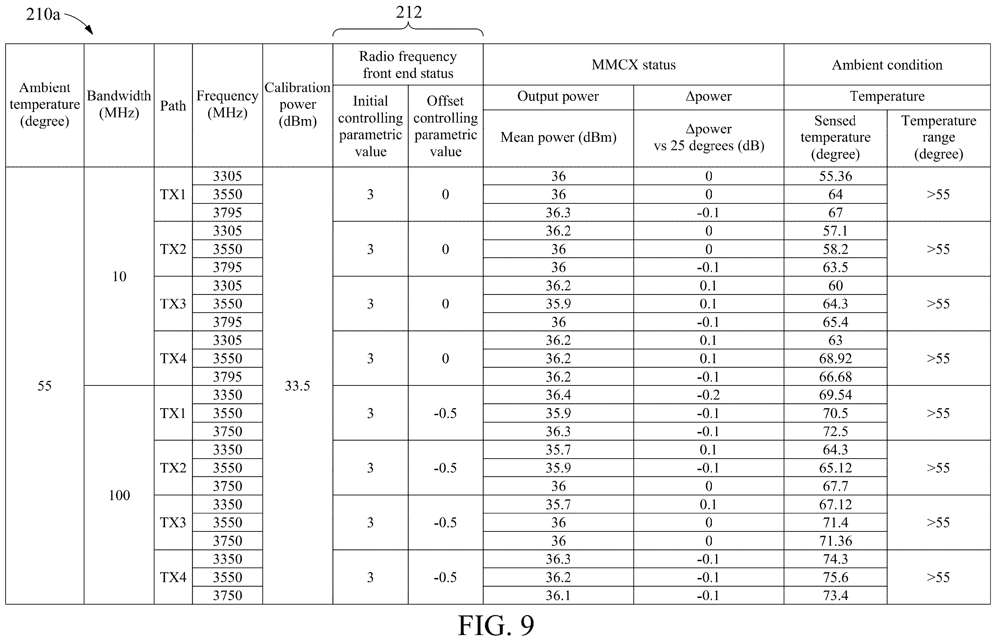

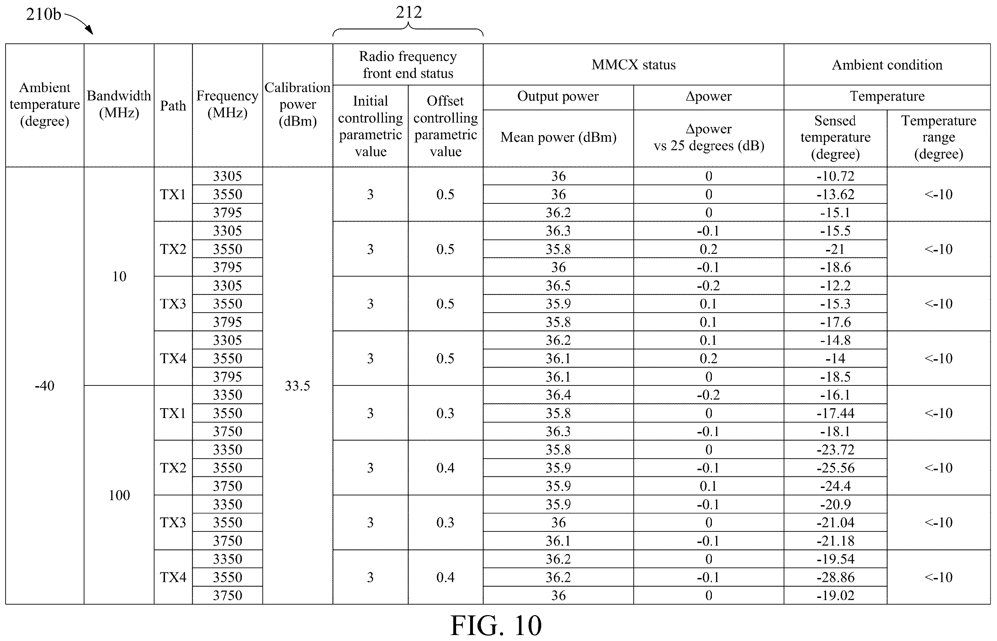

Reference is made to FIG. 1, FIG. 3, FIG. 4, FIG. 8, FIG. 9, and FIG. 10, wherein FIG. 9 is a schematic diagram of a power compensation controlling information 210a at the ambient temperature of 55 degrees, illustrated in accordance with the present invention; and FIG. 10 is a schematic diagram of a power compensation controlling information 210b at the ambient temperature of -45 degrees, illustrated in accordance with the present invention. Under different ambient temperatures, the offset controlling parametric value (compensation to the transmitting power of the transmitter TX of the radio frequency front end module 112 according to the ambient temperature) of the power compensation controlling parameter 212 in the present invention can be adaptively adjusted, such that all of the mean power value and the Δpower value fall into the standard specification range (the standard specification range of the mean power includes: (1) Room temperature and low temperature are 36dBm-36.5dBm, (2) High temperature is 35.5dBm-36dBm; the standard specification range of the Δpower is the absolute value thereof being lower than or equal to 0.5dB). In addition, from FIG. 4, FIG. 9, and FIG. 10, the present invention can further let the absolute value of the Δpower be lower than or equal to 0.2dB by utilizing the power compensation controlling information 210, 210a, 210b, and CLGC technique, which effectively promotes systematic performance and stability.

From the embodiments mentioned above, the present invention has the following advantages: First, utilizing the power compensation controlling parameter of the power compensation controlling information to develop an optimized running configuration to achieve the optimized power compensation mechanism of the present electronic device. Second, ensuring the system maintains a certain stability and performance under different ambient conditions (such as the temperature change under high temperature/ room temperature/ low temperature, bandwidth or path changes) through the power compensation mechanism. Third, combining the power compensation mechanism and the energy saving mechanism of the transmitting power with respect to temperature changes can not only enhance the systematic performance and stability, but also reduce energy consumption.

## Claims

1. A power compensation method (S0, S2, S4, S6), applied to an electronic device (110), the electronic device (110) comprising at least one power amplifier (PA), the power compensation method (S0, S2, S4, S6) **characterized in** comprising:
obtaining a power compensation controlling information (210) corresponding to a plurality of ambient temperatures (T_env) by a processor (400), and writing the power compensation controlling information (210) into a running configuration of the electronic device (110), wherein the power compensation controlling information (210) comprises a plurality of temperature ranges corresponding to the plurality of ambient temperatures (T_env), the plurality of temperature ranges comprise a first temperature range and a second temperature range, the first temperature range and the second temperature range are different;
performing the running configuration by the electronic device (110) according to the power compensation controlling information (210) and a current ambient temperature (220), wherein the current ambient temperature (220) corresponds to one of the plurality of ambient temperatures (T_env);
sensing the at least one power amplifier (PA) by a temperature sensing module (300) to generate at least one sensed temperature; and
after a period of time, judging whether the at least one sensed temperature being switched from the first temperature range to the second temperature range by the processor (400) to generate a judgment result, then determining whether to perform the running configuration based on the judgment result by the electronic device (110) according to the power compensation controlling information (210) corresponding to the second temperature range.

2. The power compensation method (S0, S2, S4, S6) of claim 1, wherein,
when the judgment result is Yes, the electronic device (110) performs the running configuration according to the power compensation controlling information (210) corresponding to the second temperature range; and
when the judgment result is No, repeating the sensing the at least one power amplifier (PA) by the temperature sensing module (300).

3. The power compensation method (S0, S2, S4, S6) of any of claims 1-2, further comprising:
detecting a change of a total power of the electronic device (110) by a power sensor (500), and judging whether the change of the total power is larger than the total power before change multiplied by a predetermined multiplier by the processor (400) to generate a power change judgment result; and
determining whether to perform a power compensation value adjustment process by the processor (400) according to the power change judgment result;
wherein the power compensation value adjustment process comprises adjusting a power compensation controlling parameter (212) corresponding to one of the at least one power amplifier (PA) in the power compensation controlling information (210) by the processor (400) to generate an adjusted power compensation controlling parameter, and performing the running configuration by the electronic device (110) according to the adjusted power compensation controlling parameter.

4. The power compensation method (S0, S2, S4, S6) of any of claims 1-3, wherein,
when the power change judgment result is Yes, performing the power compensation value adjustment process by the processor (400); and
when the power change judgment result is No, repeating the sensing the at least one power amplifier (PA) by the temperature sensing module (300).

5. The power compensation method (S0, S2, S4, S6) of any of claims 1-4, wherein the power compensation controlling parameter (212) comprises an initial controlling parametric value and an offset controlling parametric value, the processor (400) calculates the initial controlling parametric value and the offset controlling parametric value to generate an offset power compensation controlling parametric value, the adjusted power compensation controlling parameter is equal to the offset power compensation controlling parametric value subtracting a predetermined adjusting value.

6. The power compensation method (S0, S2, S4, S6) of any of claims 1-5, wherein the electronic device (110) is an Open Radio Access Network (ORAN) Radio Unit (RU), the period of time is larger than or equal to 250 seconds and smaller than or equal to 350 seconds, the plurality of ambient temperatures (T_env) are smaller than or equal to 55 degrees and larger than or equal to -40 degrees, the predetermined multiplier is larger than or equal to 1.01 and smaller than or equal to 1.09, the initial controlling parametric value is a positive integer, the offset controlling parametric value is larger than or equal to -1 and smaller than or equal to 1, the predetermined adjusting value is larger than or equal to 0.1 and smaller than or equal to 1.

7. The power compensation method (S0, S2, S4, S6) of any of claims 1-6, wherein,
the power compensation controlling information (210) further comprises a power compensation controlling parameter (212) corresponding to one of the at least one power amplifier (PA); and
the performing the running configuration by the electronic device (110) according to the power compensation controlling information (210) and the current ambient temperature (220) further comprises:
driving the one of the at least one power amplifier (PA) by the electronic device (110) according to the power compensation controlling parameter (212) corresponding to the current ambient temperature (220).

8. The power compensation method (S0, S2, S4, S6) of any of claims 1-7, further comprising:
applying a moving average approach to the at least one sensed temperature by the processor (400) to record into a memory (200);
wherein the memory (200) is connected to the processor (400).

9. The power compensation method (S0, S2, S4, S6) of any of claims 1-8, further comprising:
performing an information development process by the temperature sensing module (300) and the processor (400) to obtain the power compensation controlling information (210), wherein the information development process comprises:
sensing one of the at least one power amplifier (PA) by the temperature sensing module (300) in a predetermined time interval to generate a plurality of measured temperature values (T_sensor), and calculating a mean after summing the plurality of measured temperature values (T_sensor) to generate one of the at least one sensed temperature, wherein the one of the at least one sensed temperature is a mean sensed temperature.

10. The power compensation method (S0, S2, S4, S6) of any of claims 1-9, wherein the information development process further comprises:
obtaining a plurality of the mean sensed temperatures corresponding to the plurality of ambient temperatures (T_env) by the processor (400), and calculating a median value according to two adjacent mean sensed temperatures of the plurality of mean sensed temperatures to obtain one of the plurality of temperature ranges, wherein the one of the plurality of temperature ranges is equal to the median value.

11. A power compensation system (100), applied to an electronic device (110), the electronic device (110) comprising at least one power amplifier (PA), the power compensation system (100) **characterized in** comprising:
a memory (200), configured to store a power compensation controlling information (210) and a current ambient temperature (220), wherein the power compensation controlling information (210) corresponds to a plurality of ambient temperatures (T_env), and comprises a plurality of temperature ranges corresponding to the plurality of ambient temperatures (T_env), the plurality of temperature ranges comprise a first temperature range and a second temperature range, the first temperature range and the second temperature range are different, the current ambient temperature (220) corresponds to one of the plurality of ambient temperatures (T_env);
a temperature sensing module (300), configured to sense the at least one power amplifier (PA) to generate at least one sensed temperature; and
a processor (400), connected to the memory (200) and the temperature sensing module (300), the processor (400) obtaining the power compensation controlling information (210), and writing the power compensation controlling information (210) into a running configuration of the electronic device (110), after a period of time the processor (400) judging whether the at least one sensed temperature being switched from the first temperature range to the second temperature range to generate a judgment result, and determining, based on the judgment result, whether to perform the running configuration by the electronic device (110) according to the power compensation controlling information (210) corresponding to the second temperature range;
wherein the electronic device (110) performs the running configuration according to the power compensation controlling information (210) and the current ambient temperature (220).

12. The power compensation system (100) of claim 11, wherein,
when the judgment result is Yes, the electronic device (110) performs the running configuration according to the power compensation controlling information (210) corresponding to the second temperature range; and
when the judgment result is No, the temperature sensing module (300) repeats sensing the at least one power amplifier (PA).

13. The power compensation system (100) of any of claims 11-12, further comprising:
a power sensor (500), connected to the processor (400), the power sensor (500) detecting a change of a total power of the electronic device (110);
wherein the processor (400) judges whether the change of the total power is larger than the total power before change multiplied by a predetermined multiplier to generate a power change judgment result, and determines whether to perform a power compensation value adjustment process according to the power change judgment result;
wherein the power compensation value adjustment process comprises adjusting a power compensation controlling parameter (212) corresponding to one of the at least one power amplifier (PA) in the power compensation controlling information (210) to generate an adjusted power compensation controlling parameter, and performing the running configuration by the electronic device (110) according to the adjusted power compensation controlling parameter.

14. The power compensation system (100) of any of claims 11-13, wherein,
when the power change judgment result is Yes, the processor (400) performs the power compensation value adjustment process; and
when the power change judgment result is No, the temperature sensing module (300) repeats sensing the at least one power amplifier (PA).

15. The power compensation system (100) of any of claims 11-14, wherein the power compensation controlling parameter (212) comprises an initial controlling parametric value and an offset controlling parametric value, the processor (400) calculates the initial controlling parametric value and the offset controlling parametric value to generate an offset power compensation controlling parametric value, the adjusted power compensation controlling parameter is equal to the offset power compensation controlling parametric value subtracting a predetermined adjusting value.

16. The power compensation system (100) of any of claims 11-15, wherein the electronic device (110) is an Open Radio Access Network (ORAN) Radio Unit (RU), the period of time is larger than or equal to 250 seconds and smaller than or equal to 350 seconds, the plurality of ambient temperatures (T_env) are smaller than or equal to 55 degrees and larger than or equal to -40 degrees, the predetermined multiplier is larger than or equal to 1.01 and smaller than or equal to 1.09, the initial controlling parametric value is a positive integer, the offset controlling parametric value is larger than or equal to -1 and smaller than or equal to 1, the predetermined adjusting value is larger than or equal to 0.1 and smaller than or equal to 1.

17. The power compensation system (100) of any of claims 11-16, wherein,
the power compensation controlling information (210) further comprises a power compensation controlling parameter (212) corresponding to one of the at least one power amplifier (PA); and
the electronic device (110) drives the one of the at least one power amplifier (PA) according to the power compensation controlling parameter (212) corresponding to the current ambient temperature (220).

18. The power compensation system (100) of any of claims 11-17, wherein the processor (400) applies a moving average approach to the at least one sensed temperature to record into the memory (200).

19. The power compensation system (100) of any of claims 11-18, wherein,
the temperature sensing module (300) and the processor (400) perform an information development process to obtain the power compensation controlling information (210), wherein the information development process comprises:
sensing one of the at least one power amplifier (PA) by the temperature sensing module (300) under a predetermined time interval to generate a plurality of measured temperature values (T_sensor), and calculating a mean after summing the plurality of measured temperature values (T_sensor) to generate one of the at least one sensed temperature, wherein the one the at least one sensed temperature is a mean sensed temperature.

20. The power compensation system (100) of any of claims 11-19, wherein the information development process further comprises:
obtaining a plurality of the mean sensed temperatures corresponding to the plurality of ambient temperatures (T_env) by the processor (400), and calculating a median value according to two adjacent mean sensed temperatures of the plurality of mean sensed temperatures to obtain one of the plurality of temperature ranges, wherein the one of the plurality of temperature ranges is equal to the median value.
